# EUROPEAN PATENT APPLICATION

(11) **EP 4 648 577 A2**
(43) Date of publication of application: **12.11.2025**
(21) Application number: 25163497.8
(22) Date of filing: 13.03.2025
(51) Int. Cl.: H10D 84/01, H10D 30/01, H10D 30/00, H10D 84/03, H10D 84/85, H10D 88/00

(54) **FORKSHEET TRANSISTOR STRUCTURE HAVING CONDUCTIVE WALL**

(30) Priority: 07.05.2024 US 202463643642 P; 28.08.2024 US 202418817681
(71) Applicant: Samsung Electronics Co., Ltd., Suwon-si, Gyeonggi-do 16677 (KR)
(72) Inventor: SHIN, Hyojong, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Forksheet field-effect transistor (FET) devices are provided. A forksheet FET device includes a first FET (116a) having a first conductive gate material (182). The forksheet FET device includes a second FET (116b) that is adjacent to the first FET (116a) and that has the first conductive gate material (182). Moreover, the forksheet FET device includes a conductive wall (130) that separates the first FET (116a) from the second FET (116b). The conductive wall (130) includes a second conductive gate material (132) that is different from the first conductive gate material (182).

## Description

### TECHNICAL FIELD

The present disclosure generally relates to the field of semiconductor devices and, more particularly, to forksheet transistor structures.

### BACKGROUND OF THE INVENTION

The size of transistors in integrated circuit (IC) devices has continued to decrease to down-scale logic elements. This has resulted in the development of gate-all-around (GAA) structures such as multi-bridge channel field-effect transistors (MBCFETs^{™}) and nanosheet FETs (NSFETs). Moreover, as technology to increase transistor density has continued to develop, three-dimensional (3D) device structures, such as stacked transistors, are under consideration.

A stacked transistor (or "transistor stack") may include a first transistor and a second transistor. The first transistor may be a first type of transistor (e.g., an n-type metal-oxide-semiconductor (NMOS) transistor), and the second transistor may be a second type of transistor (e.g., a p-type metal-oxide-semiconductor (PMOS) transistor). The first and second types of transistors may be complementary to each other, and thus may be part of a complementary metal-oxide-semiconductor (CMOS) IC. The first and second transistors may be stacked vertically in any order (e.g., first on top of second, or second on top of first), thereby resulting in a stack comprising a top/upper transistor and a bottom/lower transistor.

Another type of device structure under consideration is a forksheet transistor. The forksheet transistor may include a first transistor and a second transistor that are adjacent to each other, for example horizontally side by side. The first transistor may be a first type of transistor (e.g., an n-type FET), and the second transistor may be a second type of transistor (e.g., a p-type FET). The first and second transistors may be horizontally separated from each other on opposing sides of a dielectric wall, which may allow for reduced spacing.

### SUMMARY OF THE INVENTION

A forksheet FET device, according to some embodiments herein, may include a first FET having a first conductive gate material. The forksheet FET device may include a second FET that is adjacent to the first FET and that has the first conductive gate material. Moreover, the forksheet FET device may include a conductive wall that separates the first FET from the second FET. The conductive wall may include a second conductive gate material that is different from the first conductive gate material. In some embodiments, the first conductive gate material may comprise a first metal, and the second conductive gate material may comprise a second metal that is different from the first metal. In some embodiments, the first FET and the second FET may each comprise semiconductor channel layers, the conductive wall may be part of a gate structure that separates the first FET from the second FET, and the gate structure may further comprises a dielectric material that separates the conductive wall from the semiconductor channel layers. In some embodiments, the dielectric material may comprises silicon dioxide or an oxide that has a higher dielectric constant than silicon dioxide, and the dielectric material may be on opposite sides of the conductive wall and may be in contact with both the first FET and the second FET. In some embodiments, the conductive wall may extend continuously from a lower level that is lower than a lowermost one of the semiconductor channel layers to an upper level that is higher than an uppermost one of the semiconductor channel layers. In some embodiments, the conductive wall may be at a cell boundary of the forksheet FET device. In some embodiments, the conductive wall may be configured to control a threshold voltage of the forksheet FET device. In some embodiments, the first FET and the second FET may be both p-type metal-oxide-semiconductor, PMOS, transistors or may be both n-type metal-oxide-semiconductor, NMOS, transistors. In some embodiments, the forksheet FET device may further comprise: a first gate contact that is on the first conductive gate material and is configured to bias a first gate structure that includes the first conductive gate material; and a second gate contact that is on the conductive wall and is configured to bias a second gate structure that includes the conductive wall. In some embodiments, the second gate contact may be in contact with the conductive wall. In some embodiments, the forksheet FET device may comprise a stacked forksheet FET structure in which the first FET is a first lower FET and the second FET is a second lower FET that is separated from the first lower FET by the conductive wall, and the stacked forksheet FET structure may further comprise: a first upper FET that is on top of the first lower FET; and a second upper FET that is on top of the second lower FET, and the first lower FET and the second lower FET may each comprise a p-type metal-oxide-semiconductor, PMOS, transistor and the first upper FET and the second upper FET may each comprise an n-type metal-oxide-semiconductor, NMOS, transistor, or vice versa. In some embodiments, the forksheet FET may further comprise a second conductive wall that separates the first upper FET from the second upper FET, the first conductive gate material may be part of a first gate structure, the conductive wall that separates the first lower FET from the second lower FET may be part of a second gate structure, the second conductive wall may be part of a third gate structure, and the second conductive wall may be on top of the conductive wall. In some embodiments, the forksheet FET may further comprise an isolation region that separates the second conductive wall of the third gate structure from the conductive wall of the second gate structure, the second gate structure may be configured to control a threshold voltage of the first lower FET and the second lower FET, and the third gate structure may be configured to control a threshold voltage of the first upper FET and the second upper FET. In some embodiments, the forksheet FET device may further comprise a third conductive wall that is adjacent to a sidewall of the first upper FET and a sidewall of the first lower FET, and the third conductive wall may be spaced apart from the isolation region. In some embodiments, the first FET and the second FET may each comprise a p-type metal-oxide-semiconductor (PMOS) transistor, the first conductive gate material may be part of a first gate structure, the conductive wall that separates the first FET from the second FET may be part of a second gate structure, and the forksheet FET device may further comprise: a third FET and a fourth FET that each comprise an n-type metal-oxide-semiconductor, NMOS, transistor; and a third gate structure comprising a second conductive wall that separates the third FET from the fourth FET, the third FET may be adjacent to and side by side with the second FET, and the third FET may be between the second FET and the fourth FET. In some embodiments, the second conductive wall of the third gate structure may comprise a different metal from that of the conductive wall of the second gate structure.

A forksheet FET device, according to some embodiments herein, may include a first FET having a first conductive gate material. The forksheet FET device may include a second FET that is adjacent to the first FET and that has the first conductive gate material. Moreover, the forksheet FET device may include a second conductive gate material that is between the first FET and the second FET and that is different from the first conductive gate material. The first FET and the second FET may each be the same conductivity type transistor. In some embodiments, the first conductive gate material may be part of a first gate electrode, and the second conductive gate material may be part of a second gate electrode that is a high-k metal gate (HKMG) electrode.

A forksheet FET device, according to some embodiments herein, may include a first FET. The forksheet FET device may include a second FET that is side by side with the first FET and that has the same conductivity type as the first FET. Moreover, the forksheet FET device may include a gate material that separates the first FET from the second FET and that is configured to control a threshold voltage of the forksheet FET device. In some embodiments, the first FET and the second FET may each comprise a first gate metal, and the gate material may comprises a second gate metal that is different from the first gate metal.

### BRIEF DESCRIPTION OF THE DRAWINGS

FIG. 1A is a plan view of a forksheet FET structure of a transistor device according to exemplary embodiments.
FIG. 1B is a cross-sectional view of the forksheet FET structure of FIG. 1A along the line A-A'.
FIG. 1C is a cross-sectional view of the forksheet FET structure of FIG. 1A along the line B-B'.
FIG. 2A is a plan view of a forksheet FET structure of a transistor device according to exemplary embodiments.
FIG. 2B is a cross-sectional view of the forksheet FET structure of FIG. 2A along the line A-A'.
FIG. 2C is a cross-sectional view of the forksheet FET structure of FIG. 2A along the line B-B'.
FIG. 3A is a plan view of a stacked forksheet FET structure of a transistor device according to exemplary embodiments.
FIG. 3B is a cross-sectional view of the stacked forksheet FET structure of FIG. 3A along the line A-A'.

### DETAILED DESCRIPTION

Pursuant to embodiments herein, adjacent transistors in a forksheet transistor structure may be separated from each other by a conductive wall instead of a conventional dielectric wall. The conductive wall may be part of a gate structure that is different from a main (i.e., primary) gate structure of the adjacent transistors. For example, the conductive wall may include a different metal from that of the main gate structure of the adjacent transistors. As a result, the conductive wall can allow additional threshold-voltage control for the forksheet transistor structure, beyond control that may be provided by a work function metal (WFM) of the forksheet transistor structure. The conductive wall may be referred to herein as being part of a "second," or secondary, gate structure of the forksheet transistor structure.

Moreover, though forksheet transistor structures typically include a PMOS transistor on one side of a dielectric wall and an NMOS transistor on the other (i.e., opposite) side of the dielectric wall, it may be desirable (e.g., advantageous) to have the same type of transistor on both sides. Embodiments herein may thus provide a forksheet transistor structure that has two PMOS transistors, or two NMOS transistors, on opposite sides, respectively, of the conductive wall that replaces the conventional dielectric wall.

In some embodiments, a forksheet transistor structure may be combined with a stacked transistor structure. This combination provides a 3D device structure that can reduce an area of an IC device, and may be referred to herein as a "forksheet stacked" (or "stacked forksheet") transistor structure. The forksheet stacked transistor structure may be, for example, a forksheet stacked FET structure that includes a first upper FET stacked on a first lower FET and a second upper FET stacked on a second lower FET. The forksheet stacked FET can increase transistor density beyond the capability of a conventional (i.e., non-forksheet) stacked FET.

Example embodiments will be described in greater detail with reference to the attached figures.

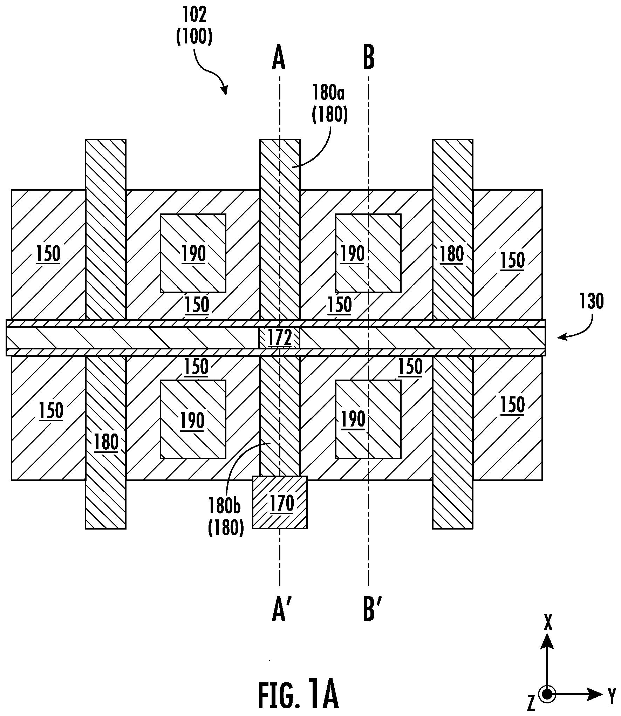

FIG. 1A is a plan view of a forksheet FET structure 102 of a transistor (i.e., IC) device 100 according to some embodiments herein. The forksheet FET structure 102 includes a first gate structure 180 having a first portion 180a and a second portion 180b that are separated from each other, in a first horizontal (i.e., lateral) direction X, by a second gate structure 130. The first gate structure 180 may extend longitudinally (i.e., primarily) in the direction X. The second gate structure 130, on the other hand, may extend longitudinally in a second horizontal (i.e., lateral) direction Y, which may be perpendicular to the direction X. The directions X, Y may both be perpendicular to a vertical direction Z.

In some embodiments, the first and second portions 180a, 180b of the first gate structure 180 may have the same conductive gate material, which may be different from a conductive gate material of the second gate structure 130. The first and second portions 180a, 180b may thus be referred to herein collectively as a single "gate structure," or "gate electrode," that is divided (into the two portions 180a, 180b) by the second gate structure 130. Moreover, the transistor device 100 may include additional first gate structures 180 that are divided by the second gate structure 130. The first gate structures 180 may be spaced apart from each other in the direction Y.

Source/drain (S/D) regions 150 may be on opposite sides of each of the first gate structures 180. The S/D regions 150 may comprise, for example, silicon germanium, and may thereby provide PMOS transistors. S/D contacts 190 may be on the S/D regions 150. A first electrical node 170 may be on and electrically connected to the second portion 180b (or the first portion 180a) of the first gate structure 180, and a second electrical node 172 may be on and electrically connected to the second gate structure 130. The second gate structure 130 may thus be biased independently of the first gate structure 180. Moreover, the first and second electrical nodes 170, 172 may be collinear (i.e., aligned) with each other in the direction X.

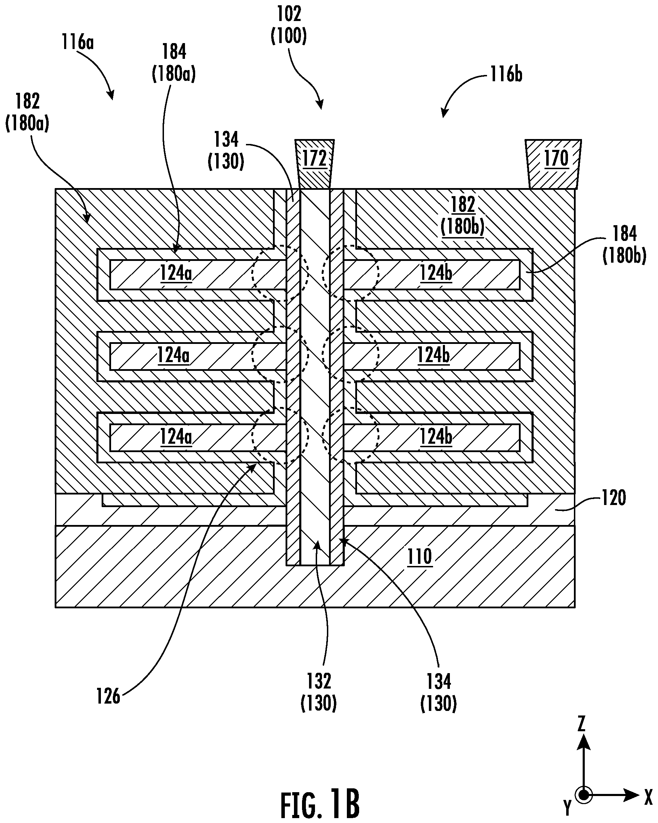

FIG. 1B is a cross-sectional view of the forksheet FET structure 102 along the line A-A' of FIG. 1A. As shown in FIG. 1B, the forksheet FET structure 102 includes a first FET 116a and a second FET 116b that are separated from each other, in the direction X, by the second gate structure 130. The first FET 116a includes a stack of semiconductor channel layers 124a, and the second FET 116b includes a stack of semiconductor channel layers 124b.

The second gate structure 130 includes a conductive wall 132. The conductive wall 132 comprises a conductive gate material of the second gate structure 130. For example, the conductive gate material may be a metal.

The second gate structure 130 may also include a dielectric material 134 that separates the conductive wall 132 from the first and second portions 180a, 180b of the first gate structure 180. In some embodiments, the dielectric material 134 may be on opposite sides, in the direction X, of the conductive wall 132. The conductive wall 132 may thus be between, in the direction X, first and second portions/regions of the dielectric material 134. The dielectric material 134 may comprise an oxide, such as an oxide that has a higher dielectric constant than silicon dioxide. Accordingly, the dielectric material 134 may be a high-k dielectric material, and the second gate structure 130 may be a high-k metal gate (HKMG). In other embodiments, the dielectric material 134 may be silicon dioxide. The channel layers 124a, 124b may be separated from the conductive wall 132 by the dielectric material 134. The conductive wall 132 is a vertical wall that may overlap all of the channel layers 124a, 124b in the direction X. As an example, the conductive wall 132 may extend continuously from a lower level that is lower than lowermost ones of the channel layers 124a, 124b to an upper level that is higher than uppermost ones of the channel layers 124a, 124b.

The first and second FETs 116a, 116b also include the first and second portions 180a, 180b, respectively, of the first gate structure 180. The first and second portions 180a, 180b may each comprise a conductive gate material 182 and a dielectric material 184. For example, the conductive gate material 182 may be a metal that is different from a metal of the conductive wall 132 of the second gate structure 130. The conductive gate material 182 is on, and between, the channel layers 124a of the first FET 116a. The conductive gate material 182 is also on, and between, the channel layers 124b of the second FET 116b. The conductive wall 132, on the other hand, is a vertical wall that is not between the channel layers 124a (and is not between the channel layers 124b) in the direction Z.

Because the first and second FETs 116a, 116b may each be the same conductivity type transistor (i.e., may both be PMOS transistors or may both be NMOS transistors), they can include the same conductive gate material 182 (e.g., the same metal). The conductive gate material 182 of the first and second portions 180a, 180b of the first gate structure 180 may vary based on whether the first and second portions 180a, 180b are for PMOS transistors or NMOS transistors. For example, the conductive gate material 182 may comprise a first metal if the first and second portions 180a, 180b are both for PMOS transistors, or may comprise a different, second metal if the first and second portions 180a, 180b are both for NMOS transistors.

Examples of the conductive gate material 182 include metals such as titanium, aluminum, tungsten, cobalt, ruthenium, molybdenum, nickel, and various alloys. The conductive gate material 182 may thus also be referred to herein as a "gate metal." In some embodiments, the conductive gate material 182 may include, for example, titanium nitride, titanium carbide, and/or titanium aluminum carbide as a WFM and may further include tungsten as a gate metal fill. Other metals that may be used as the gate metal fill include cobalt, ruthenium, molybdenum, nickel, and various alloys. The conductive wall 132 may also include one or more of these materials (e.g., titanium, aluminum, tungsten, cobalt, ruthenium, molybdenum, nickel, and various alloys), and may omit/exclude one or more of these materials that is included in the conductive gate material 182. As an example, the conductive gate material 182 may include a first one (or a first combination) of these materials, and the conductive wall 132 may include a different, second one (or a different, second combination) of these materials. The conductive wall 132 may thus also be referred to herein as a "second conductive gate material."

The dielectric material 184 may be, for example, an oxide, such as a high-k oxide. The dielectric material 184 is between the channel layers 124a, 124b and the conductive gate material 182. The dielectric material 134, on the other hand, is part of a vertical structure that may be absent between the channel layers 124a (and absent between the channel layers 124b) in the direction Z.

According to some embodiments, the second gate structure 130 may be in contact with both the first portion 180a and the second portion 180b of the first gate structure 180, and thus may be in contact with both the first FET 116a and the second FET 116b. For example, opposite sidewalls of the dielectric material 134 of the second gate structure 130 may contact the dielectric material 184 of the first and second portions 180a, 180b, respectively. Moreover, the dielectric material 134 may contact the channel layers 124a and/or the channel layers 124b. As an example, a sidewall of a first portion/region of the dielectric material 134 may contact sidewalls of the channel layers 124a, and a sidewall of an opposite, second portion/region of the dielectric material 134 may contact sidewalls of the channel layers 124b.

The second gate structure 130 can provide control of a threshold voltage of the forksheet FET structure 102, in addition to control that may be provided by the conductive gate material 182 of the first and second portions 180a, 180b of the first gate structure 180. Broken-line circles 126 in FIG. 1B illustrate regions of the channel layers 124a, 124b adjacent to the second gate structure 130 where the second gate structure 130 can provide this additional threshold-voltage control. The regions indicated by the broken-line circles 126 may include interfaces where the dielectric material 134 of the second gate structure 130 is in contact with the channel layers 124a, 124b.

The first and second FETs 116a, 116b are adjacent transistors that are side by side with each other in the direction X. As used herein, the term "adjacent transistors" (or "FET [that] is adjacent to [another] FET") refers to a pair of transistors having no other transistor therebetween in the direction X. In some embodiments, the adjacent transistors are separated from each other only by a gate structure having a conductive wall, such as the second gate structure 130 having the conductive wall 132.

The first and second portions 180a, 180b of the first gate structure 180 are on a substrate 110, which may be a silicon, or other semiconductor, substrate. According to some embodiments, an isolation region 120, such as a bottom dielectric isolation (BDI) layer, may be between the substrate 110 and the first and second portions 180a, 180b in the direction Z. The second gate structure 130 may extend through the isolation region 120 and into an upper portion of the substrate 110. The second gate structure 130 may thus have a lower surface that is at a lower level than lower surfaces of the first and second portions 180a, 180b. An upper surface of the second gate structure 130 may be coplanar with upper surfaces of the first and second portions 180a, 180b in some embodiments.

The first electrical node 170 may be on an upper surface of the conductive gate material 182 of the second portion 180b (or of the first portion 180a) of the first gate structure 180. The second electrical node 172 may be on an upper surface of the conductive wall 132 of the second gate structure 130. For example, the first and second electrical nodes 170, 172 may be conductive (e.g., metal) nodes that are in contact with (and electrically connected to) the upper surfaces of the conductive gate material 182 and the conductive wall 132, respectively. The first and second electrical nodes 170, 172, which may also be referred to herein as "gate contacts," can thus be configured to control (e.g., bias) the first gate structure 180 and the second gate structure 130, respectively.

The first gate structure 180 comprises a main gate electrode that controls the gate of the first FET 116a (and the gate of the second FET 116b). The second gate structure 130 is an additional gate electrode that can electrically connect a power supply to the forksheet FET structure 102 so that a threshold voltage of the forksheet FET structure 102 can be additionally controlled (e.g., increased or decreased). As an example, a direct current (DC) bias may be provided from a power supply to the second gate structure 130 via the second electrical node 172 to regulate (e.g., increase or decrease) a threshold voltage of the first and second FETs 116a, 116b. The first and second gate structures 180, 130 may thus also be referred to herein as first and second "gate electrodes," respectively.

According to some embodiments, the S/D regions 150 (FIG. 1A) may be formed by epitaxial growth. For example, the S/D regions 150 may be epitaxially grown in the direction Y from the channel layers 124a, 124b. In some embodiments, the channel layers 124a, 124b may comprise silicon, and the S/D regions 150 may comprise silicon, silicon carbide, or silicon germanium. Moreover, the direction Y may be a channel-width direction of the channel layers 124a, 124b.

For simplicity of illustration, only one forksheet FET structure 102 is shown in FIG. 1B. According to some embodiments, however, the transistor device 100 may include two, three, four, or more forksheet FET structures 102.

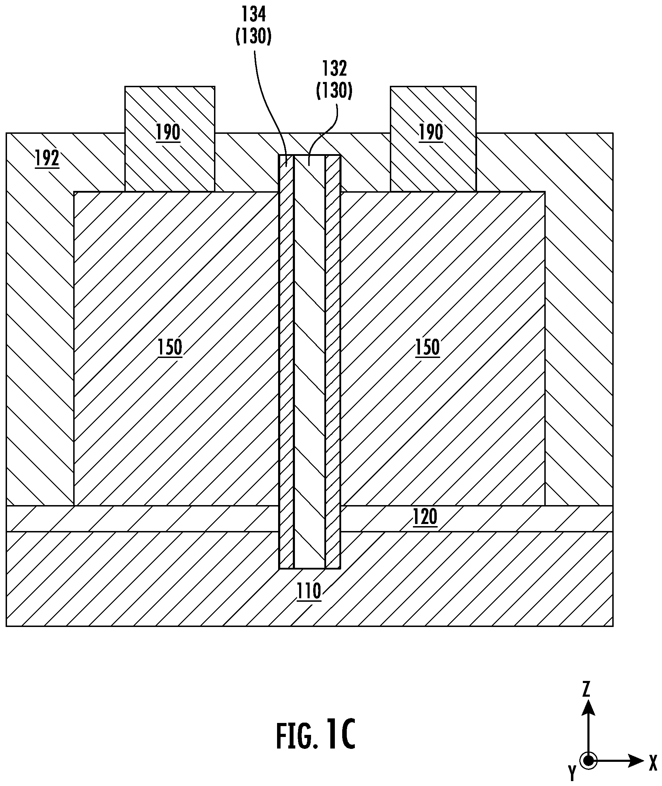

FIG. 1C is a cross-sectional view of the forksheet FET structure 102 along the line B-B' of FIG. 1A. As shown in FIG. 1C, the second gate structure 130 may extend in (e.g., may divide) an S/D region 150. In some embodiments, an isolation region 192 may be on an upper surface and side surfaces of the S/D region 150. Lower portions of the S/D contacts 190 may be in the isolation region 192. Referring again to FIG. 1A, a pair of S/D regions 150 may be adjacent opposite sides, respectively, of the first gate structure 180 in the direction Y. According to some embodiments, the S/D regions 150 may provide PMOS transistors by comprising, for example, silicon germanium. In other embodiments, the S/D regions 150 may provide NMOS transistors by comprising, for example, silicon carbide.

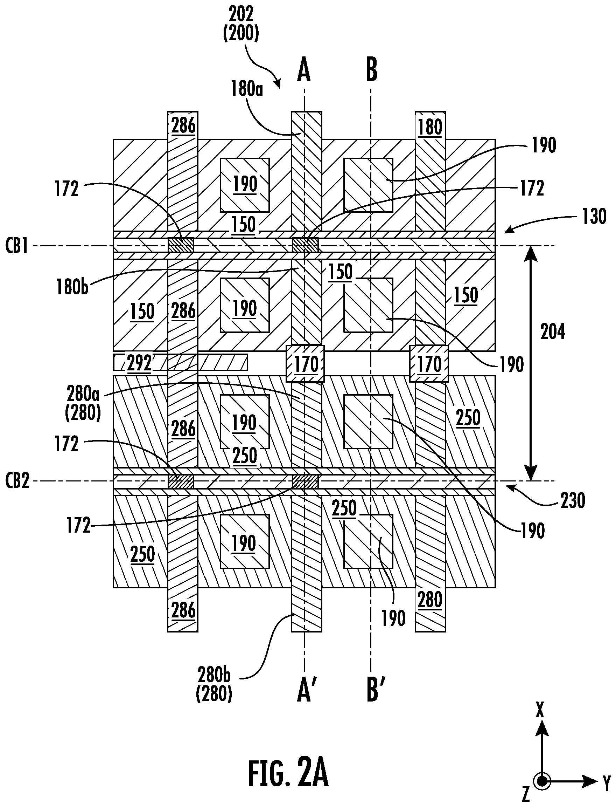

FIG. 2A is a plan view of a forksheet FET structure 202 of a transistor device 200 according to further embodiments herein. The forksheet FET structure 202 includes the second gate structure 130 of FIG. 1A that divides the first gate structure 180 into first and second portions 180a, 180b. The forksheet FET structure 202 further includes a third gate structure 230 that divides a fourth gate structure 280 into a first portion 280a and a second portion 280b. In some embodiments, the fourth gate structure 280 may be collinear (i.e., aligned) with the first gate structure 180 in the direction X.

The first and second portions 280a, 280b of the fourth gate structure 280 are separated from each other in the direction X by the third gate structure 230. The fourth gate structure 280 may extend longitudinally in the direction X. The third gate structure 230, on the other hand, may extend longitudinally in the direction Y in parallel with the second gate structure 130.

In some embodiments, the first and second portions 280a, 280b of the fourth gate structure 280 may have the same conductive gate material, which may be different from a conductive gate material of the third gate structure 230. The first and second portions 280a, 280b may thus be referred to herein collectively as a single "gate structure" that is divided (into the two portions 280a, 280b) by the third gate structure 230. Moreover, the transistor device 200 may include at least one additional fourth gate structure 280 that is divided by the third gate structure 230. The fourth gate structures 280 may be spaced apart from each other in the direction Y.

S/D regions 250 may be on opposite sides of each of the fourth gate structures 280. The S/D regions 250 may comprise, for example, silicon carbide, and may thereby provide NMOS transistors. S/D contacts 190 may be on the S/D regions 250.

A first electrical node 170 may be on the first portion 280a (or on the second portion 280b) of the fourth gate structure 280, and a second electrical node 172 may be on the third gate structure 230. The third gate structure 230 may thus be biased independently of the fourth gate structure 280. In some embodiments, a first portion of the first electrical node 170 may be on the fourth gate structure 280, and a second portion of the first electrical node 170 may be on the first gate structure 180. For example, the first electrical node 170 may be on an interface/border of the first and fourth gate structures 180, 280. Moreover, the first and second electrical nodes 170, 172 may be collinear (i.e., aligned) with each other in the direction X.

According to some embodiments, the second and third gate structures 130, 230 may be at a first cell boundary CB1 and a second cell boundary CB2, respectively, of a cell area 204 (e.g., a standard cell) of the transistor device 200. The first cell boundary CB1 may thus be at a midpoint (e.g., a center point), in the direction X, between the first and second portions 180a, 180b of the first gate structure 180. Similarly, the second cell boundary CB2 may be at a midpoint (e.g., a center point), in the direction X, between the first and second portions 280a, 280b of the fourth gate structure 280.

In some embodiments, a gate-cut region 292 may extend in the direction Y and may be between, in the direction X, the second gate structure 130 and the third gate structure 230. The gate-cut region 292 comprises an insulating material (e.g., a vertical isolation region). Moreover, the transistor device 200 may include a single diffusion break (SDB) 286 that extends in parallel with the first and fourth gate structures 180, 280 in the direction X. The SDB 286 may include an insulating material that electrically isolates transistors on one side of the SDB 286 from transistors on an opposite side of the SDB 286.

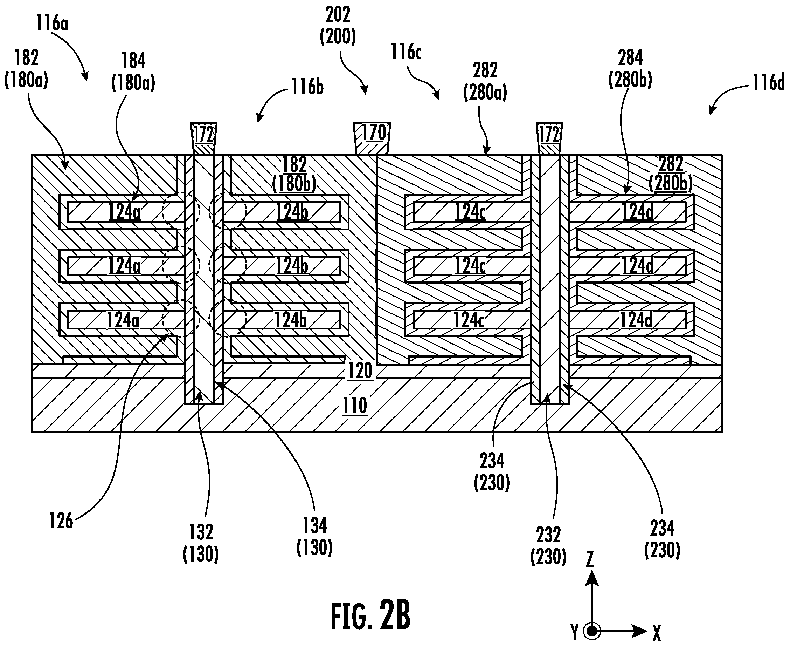

FIG. 2B is a cross-sectional view of the forksheet FET structure 202 along the line A-A' of FIG. 2A. As shown in FIG. 2B, the forksheet FET structure 202 includes a third FET 116c and a fourth FET 116d that are separated from each other, in the direction X, by the third gate structure 230. The third FET 116c includes a stack of semiconductor channel layers 124c, and the fourth FET 116d includes a stack of semiconductor channel layers 124d. The third and fourth FETs 116c, 116d are side by side with each other, and with the first and second FETs 116a, 116b, on the substrate 110 in the direction X.

The third gate structure 230 includes a conductive wall 232. The conductive wall 232 comprises a conductive gate material (e.g., a metal) of the third gate structure 230. In some embodiments, the conductive gate material of the conductive wall 232 may be the same (e.g., the same metal) as that of the conductive wall 132 of the second gate structure 130. For example, the conductive walls 132, 232 may each comprise tungsten. In other embodiments, the conductive gate material of the conductive wall 232 may be different (e.g., a different metal) from that of the conductive wall 132 of the second gate structure 130. As an example, one metal may be selected for the conductive wall 132 based on the conductivity type of the first and second FETs 116a, 116b, and a different metal may be selected for the conductive wall 232 based on the conductivity type of the third and fourth FETs 116c, 116d.

The third gate structure 230 may also include a dielectric material 234 that separates the conductive wall 232 from the first and second portions 280a, 280b of the fourth gate structure 280. The dielectric material 234 may comprise an oxide, such as silicon dioxide or an oxide that has a higher dielectric constant than silicon dioxide. Accordingly, the dielectric material 234 may be a high-k dielectric material, and the third gate structure 230 may be an HKMG. The channel layers 124c, 124d may be separated from the conductive wall 232 by the dielectric material 234. The conductive wall 232 may overlap all of the channel layers 124c, 124d in the direction X. For example, the conductive wall 232 may extend continuously from a lower level that is lower than lowermost ones of the channel layers 124c, 124d to an upper level that is higher than uppermost ones of the channel layers 124c, 124d.

The third and fourth FETs 116c, 116d also include the first and second portions 280a, 280b, respectively, of the fourth gate structure 280. The first and second portions 280a, 280b may each comprise a conductive gate material 282 and a dielectric material 284. As an example, the conductive gate material 282 may be a metal that is different from a metal of the conductive wall 232 of the third gate structure 230. The conductive gate material 282 is on, and between, the channel layers 124c of the third FET 116c. The conductive gate material 282 is also on, and between, the channel layers 124d of the fourth FET 116d. The conductive wall 232, on the other hand, is a vertical wall that is not between the channel layers 124c (and is not between the channel layers 124d) in the direction Z.

Because the third and fourth FETs 116c, 116d may each be the same conductivity type transistor (i.e., may both be NMOS transistors or may both be PMOS transistors), they can include the same conductive gate material 282 (e.g., the same metal). The conductive gate material 282 of the first and second portions 280a, 280b of the fourth gate structure 280 may vary based on whether the first and second portions 280a, 280b are for NMOS transistors or PMOS transistors. For example, the conductive gate material 282 may be a first metal if the first and second portions 280a, 280b are both for PMOS transistors, or may be a different, second metal if the first and second portions 280a, 280b are both for NMOS transistors.

The third and fourth FETs 116c, 116d may each be a different conductivity type transistor from that of the first and second FETs 116a, 116b. For example, the third and fourth FETs 116c, 116d may both be NMOS transistors while the first and second FETs 116a, 116b are both PMOS transistors. As another example, the third and fourth FETs 116c, 116d may both be PMOS transistors while the first and second FETs 116a, 116b are both NMOS transistors.

The conductive gate material 282 may comprise one or more conductive materials, such as one or more WFMs, that are different from the conductive gate material 182 of the first and second FETs 116a, 116b (which may also include one or more WFMs). Examples of the conductive gate material 282 include metals such as titanium, aluminum, tungsten, cobalt, ruthenium, molybdenum, nickel, and various alloys. The conductive gate material 282 may thus also be referred to herein as a "gate metal." In some embodiments, the conductive gate material 282 may include, for example, titanium nitride, titanium carbide, and/or titanium aluminum carbide as a WFM and may further include tungsten as a gate metal fill. Other metals that may be used as the gate metal fill include cobalt, ruthenium, molybdenum, nickel, and various alloys. The conductive wall 232 may also include one or more of these materials (e.g., titanium, aluminum, tungsten, cobalt, ruthenium, molybdenum, nickel, and various alloys). As an example, the conductive gate material 282 may include a first one (or a first combination) of these materials, and the conductive wall 232 may include a different, second one (or a different, second combination) of these materials.

The dielectric material 284 may be, for example, an oxide, such as a high-k oxide. The dielectric material 284 is between the channel layers 124c, 124d and the conductive gate material 282. The dielectric material 234, on the other hand, is part of a vertical structure that may be absent between the channel layers 124c (and absent between the channel layers 124d) in the direction Z.

According to some embodiments, the third gate structure 230 may be in contact with both the first portion 280a and the second portion 280b of the fourth gate structure 280. For example, opposite sidewalls of the dielectric material 234 of the third gate structure 230 may contact the dielectric material 284 of the first and second portions 280a, 280b, respectively. Moreover, the dielectric material 234 may contact the channel layers 124c and/or the channel layers 124d. As an example, a sidewall of a first portion/region of the dielectric material 234 may contact sidewalls of the channel layers 124c, and a sidewall of an opposite, second portion/region of the dielectric material 234 may contact sidewalls of the channel layers 124d.

The third gate structure 230 can provide control of a threshold voltage of the forksheet FET structure 202 (e.g., of the third and/or fourth FETs 116c, 116d), in addition to control that may be provided by the conductive gate material 282 of the first and second portions 280a, 280b of the fourth gate structure 280.

According to some embodiments, the isolation region 120 (e.g., a BDI layer) may be between the substrate 110 and the first and second portions 280a, 280b of the fourth gate structure 280 (as well as between the substrate 110 and the first and second portions 180a, 180b of the first gate structure 180) in the direction Z. The third gate structure 230 may extend through the isolation region 120 and into an upper portion of the substrate 110. The third gate structure 230 may thus have a lower surface that is at a lower level than lower surfaces of the first and second portions 280a, 280b. An upper surface of the third gate structure 230 may be coplanar with upper surfaces of the first and second portions 280a, 280b in some embodiments. Moreover, the upper surface of the third gate structure 230 may be coplanar with the upper surface of the second gate structure 130. As an example, an upper surface of the conductive wall 232 may be coplanar with an upper surface of the conductive wall 132.

The first electrical node 170 may be on both an upper surface of the conductive gate material 182 of the first gate structure 180 and an upper surface of the conductive gate material 282 of the fourth gate structure 280. For example, a right side (i.e., a first portion) of the first electrical node 170 may be on the upper surface of the conductive gate material 282, and a left side (i.e., a second portion) of the first electrical node 170 may be on the upper surface of the conductive gate material 182. The second electrical node 172 may be on an upper surface of the conductive wall 232 of the third gate structure 230. As an example, the first and second electrical nodes 170, 172 may be conductive (e.g., metal) nodes that are in contact with (and electrically connected to) the upper surfaces of the conductive gate material 282 (and the conductive gate material 182) and the conductive wall 232, respectively. The first and second electrical nodes 170, 172, which may be collinear (i.e., aligned) with each other in the direction X and may also be referred to herein as "gate contacts," can thus be configured to control (e.g., bias) the fourth gate structure 280 and the third gate structure 230, respectively. Moreover, other second electrical nodes 172 may be on the upper surfaces of the second and third gate structures 130, 230 and spaced apart from the first and fourth gate structures 180, 280 in the direction Y (e.g., the other second electrical nodes 172 may be adjacent to the SDB 286, as shown in FIG. 2A). A further second electrical node 172 may be on the upper surface of the conductive wall 132 of the second gate structure 130, as described herein with respect to FIG. 1B.

According to some embodiments, the S/D regions 250 (FIG. 2A) may be formed by epitaxial growth. For example, the S/D regions 250 may be epitaxially grown from the channel layers 124c, 124d in the direction Y. In some embodiments, the channel layers 124c, 124d may comprise silicon, and the S/D regions 250 may comprise silicon, silicon carbide, or silicon germanium. Moreover, the direction Y may be a channel-width direction of the channel layers 124c, 124d.

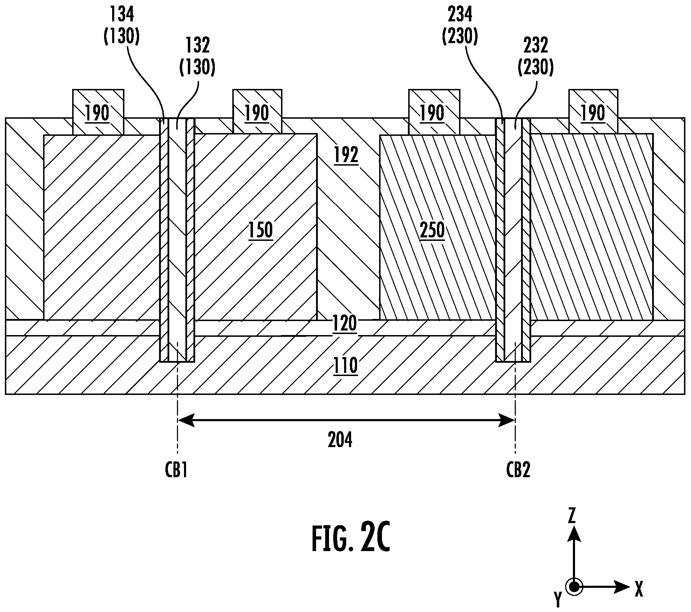

FIG. 2C is a cross-sectional view of the forksheet FET structure 202 along the line B-B' of FIG. 2A. As shown in FIG. 2C, the isolation region 192 may electrically isolate an S/D region 150 from an adjacent S/D region 250. The third gate structure 230 may extend in (e.g., may divide) the S/D region 250.

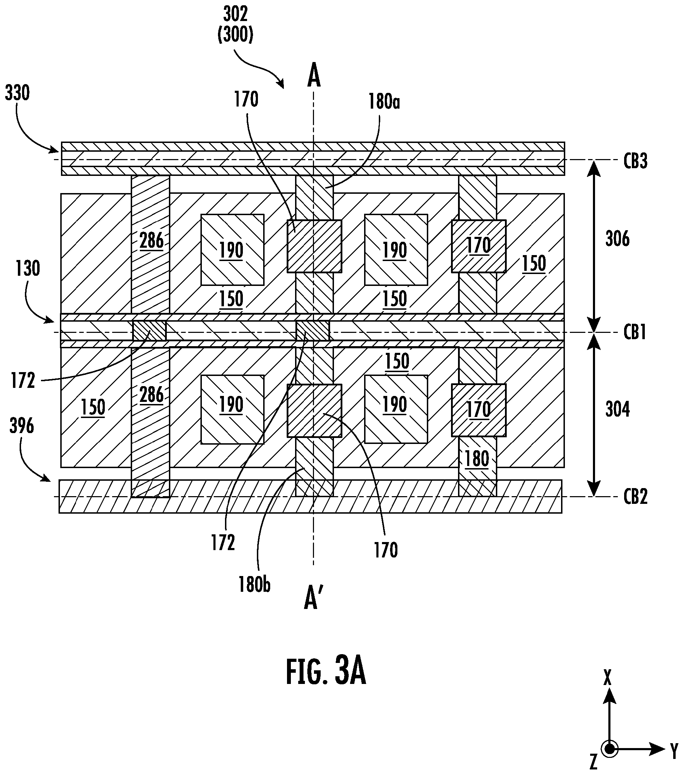

FIG. 3A is a plan view of a stacked forksheet FET structure 302 of a transistor device 300 according to some embodiments herein. The stacked forksheet FET structure 302 includes the second gate structure 130 of FIG. 1A that divides the first gate structure 180 into first and second portions 180a, 180b. The stacked forksheet FET structure 302 further includes the third gate structure 230 of FIG. 2A that divides the fourth gate structure 280 into first and second portions 280a, 280b. Unlike the forksheet FET structure 202 in FIG. 2A, however, the stacked forksheet FET structure 302 is a stacked structure in which the first gate structure 180 is stacked on (i.e., on top of) the fourth gate structure 280 and the second gate structure 130 is stacked on (i.e., on top of) the third gate structure 230. Accordingly, the stacked forksheet FET structure 302 may be referred to herein as a "stacked" forksheet transistor structure. The third and fourth gate structures 230, 280 thus may not be visible in the plan view of FIG. 3A, as they may be obscured by the first and second gate structures 180, 130 thereon.

In some embodiments, the stacked forksheet FET structure 302 may include a first cell area 304 that is side by side (e.g., contiguous) with a second cell area 306 in the direction X. The first and second cell areas 304, 306 may include the second and first portions 180b, 180a, respectively, of the first gate structure 180. The first and second cell areas 304, 306 may further include the second and first portions 280b, 280a, respectively, of the fourth gate structure 280 that is under the first gate structure 180.

The first and second cell areas 304, 306 may share a first cell boundary CB1 that has the second and third gate structures 130, 230 thereon. The first cell area 304 may also have a second cell boundary CB2 that has a cut region 396 thereon. The cut region 396 may comprise, for example, an insulating material. Moreover, the second cell area 306 may also have a third cell boundary CB3 that has a conductive structure 330 thereon.

The cut region 396 and the conductive structure 330 are two examples of regions/structures that can reduce electrical coupling with FETs of the stacked forksheet FET structure 302. According to some embodiments, the cut region 396 and the conductive structure 330 may thus be used interchangeably. For example, the positions of the cut region 396 and the conductive structure 330 may be reversed such that the cut region 396 is on the third cell boundary CB3 and the conductive structure 330 is on the second cell boundary CB2. As another example, the cut region 396 and the conductive structure 330 may be replaced with two cut regions 396, respectively, or with two conductive structures 330, respectively.

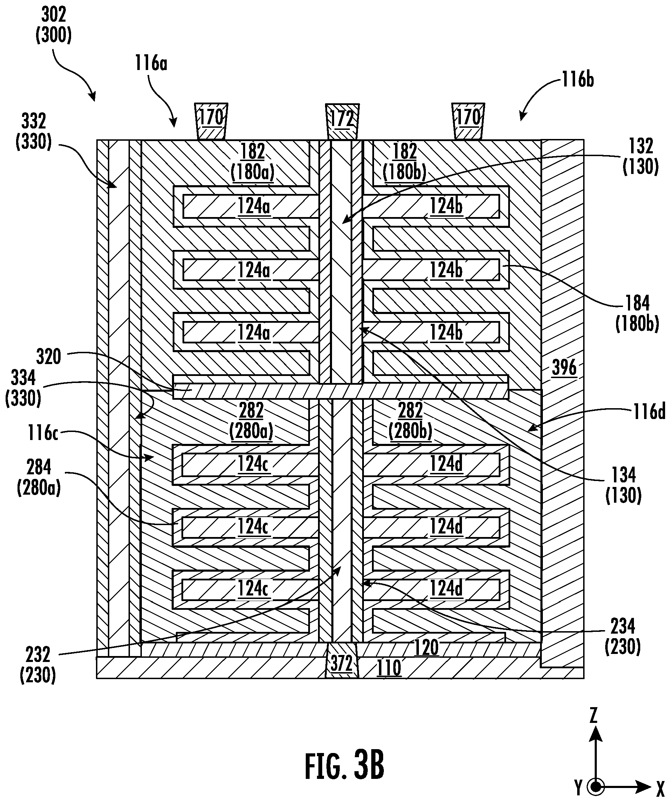

FIG. 3B is a cross-sectional view of the stacked forksheet FET structure 302 along the line A-A' of FIG. 3A. As shown in FIG. 3B, the first and second FETs 116a, 116b are upper FETs that are on top of the third and fourth FETs 116c, 116d, which are lower FETs. In some embodiments, the upper FETs are both PMOS FETs and the lower FETs are both NMOS FETs. In other embodiments, the upper FETs are both NMOS FETs and the lower FETs are both PMOS FETs. For simplicity of illustration, the first and second FETs 116a, 116b are shown in FIG. 3B as upper FETs and the third and fourth FETs 116c, 116d are shown as lower FETs. According to some embodiments, however, the first and second FETs 116a, 116b may be lower FETs and the third and fourth FETs 116c, 116d may be upper FETs that are on top of those lower FETs. Likewise, the conductive wall 232 may be on top of the conductive wall 132 instead of the arrangement that is shown in FIG. 3B.

An isolation region 320 (e.g., a middle dielectric isolation (MDI) layer) may be between, in the direction Z, at least a portion of the first gate structure 180 and at least a portion of the fourth gate structure 280. For example, the isolation region 320 may be between the second gate structure 130 that divides the first gate structure 180 and the third gate structure 230 that divides the fourth gate structure 280. In some embodiments, the isolation region 320 may be in contact with a lower surface of the second gate structure 130 and an upper surface of the third gate structure 230. Moreover, the isolation region 320 may overlap the channel layers 124c, 124d in the direction Z and may be overlapped by the channel layers 124a, 124b in the direction Z. As an example, opposite ends of the isolation region 320, in the direction X, may be aligned with opposite ends of the dielectric materials 184, 284.

A third electrical node (e.g., a third gate contact) 372 may be on a lower surface of the third gate structure 230. The third electrical node 372 may be configured to control (e.g., bias) the third gate structure 230. For example, the third electrical node 372 may be coupled between the third gate structure 230 and a power supply, and may provide a DC bias from the power supply to the third gate structure 230 to regulate (e.g., increase or decrease) a threshold voltage of the third and fourth FETs 116c, 116d. According to some embodiments, an upper portion of the third electrical node 372 may be in the isolation region 120 and a lower portion of the third electrical node 372 may be in the substrate 110. The third electrical node 372 may thus be coupled to the power supply via a back-side of the substrate 110.

In some embodiments, multiple first electrical nodes 170 may be on the first gate structure 180. As an example, respective first electrical nodes 170 may be on upper surfaces of the first and second portions 180a, 180b of the first gate structure 180. According to some embodiments, those two first electrical nodes 170 may be collinear (i.e., aligned) in the direction X, with the second electrical node 172 therebetween.

The cut region 396 may comprise a vertical isolation region that can provide electrical isolation for the FETs 116a-116d from other FETs in the transistor device 300. In some embodiments, the cut region 396 (e.g., an insulating material therein) may extend continuously in the direction Z from a level of an upper surface of the first gate structure 180 to (or lower than) a level of a lower surface of the fourth gate structure 280. Moreover, the cut region 396 (e.g., the insulating material therein) may be in contact with a sidewall of the conductive gate material 182 and a sidewall of the conductive gate material 282.

The conductive structure 330 and the cut region 396 may be on opposite sides of the first and fourth gate structures 180, 280. The conductive structure 330 may include a conductive material 332, such as a metal. The conductive structure 330 may further include a dielectric material 334. The dielectric material 334 may be in contact with a sidewall of the conductive gate material 182 and a sidewall of the conductive gate material 282. As a result, the dielectric material 334 can separate the conductive material 332 from the conductive gate materials 182, 282.

The conductive material 332 can block an electrical-coupling effect between the FETs 116a-116d and an adjacent cell of the transistor device 300. For example, as the size of cell areas in the transistor device 300 scales down, a width of a cut region in the transistor device 300 may also decrease. In such a case, the conductive material 332 can replace (i.e., be used instead of) a cut region. Likewise, the second and third gate structures 130, 230 can play the role of a cut region (e.g., vertical isolation region) and can reduce/prevent a coupling effect between two adjacent transistors.

In some embodiments, the stack structure comprising the first through fourth gate structures 180, 130, 230, 280 may be repeated (e.g., duplicated) in the transistor device 300. For simplicity of illustration, such repetition of the first through fourth gate structures 180, 130, 230, 280 is omitted from view in FIGs. 3A and 3B. It will be understood, however, that another stack of the first through fourth gate structures 180, 130, 230, 280 may be provided adjacent the stack that is shown in FIG. 3B. As an example, two stacks of the first through fourth gate structures 180, 130, 230, 280 may be adjacent to each other and separated (and electrically isolated) from each other by the conductive structure 330.

According to some embodiments, the conductive material 332 (e.g., a metal) of the conductive structure 330 may extend continuously from (or below) a level of a lower surface of the fourth gate structure 280 to (or near) a level of an upper surface of the first gate structure 180. The conductive material 332 may thus overlap all of the channel layers 124a-124d in the direction X. Moreover, the conductive material 332 may be adjacent to a sidewall of the first FET 116a and a sidewall of the third FET 116c. No conductive material (i.e., no conductive wall and no conductive gate material) may be between the conductive material 332 and the first and third FETs 116a, 116c (e.g., the conductive gate materials 182, 282 thereof) in the direction X. Rather, the conductive material 332 may be separated from the first and third FETs 116a, 116c in the direction X only by the dielectric material 334.

In some embodiments, the conductive structure 330 may have the same structure/material(s) as that of the second gate structure 130 and/or the third gate structure 230, other than that the second and third gate structures 130, 230 are separated from each other by the isolation region 320. The conductive structure 330 is spaced apart from the isolation region 320 by the conductive gate materials 182, 282 in the direction X, and is not separated/divided by any isolation region (e.g., any MDI layer). The conductive material 332 of the conductive structure 330 may thus provide a conductive wall (which may be referred to herein as a "third conductive wall"). The conductive material 332 may also include the same conductive material (e.g., the same metal) as the conductive wall 132 of the second gate structure 130 and/or the conductive wall 232 of the third gate structure 230. Moreover, the dielectric material 334 of the conductive structure 330 may include the same dielectric material (e.g., the same high-k dielectric material) as the dielectric material 134 of the second gate structure 130 and/or the dielectric material 234 of the third gate structure 230. As a result of having the same structure/material(s) as that of the second gate structure 130 and/or the third gate structure 230, the conductive structure 330 may be formed at a lower cost than if the conductive structure 330 had a different structure/material(s).

Transistor devices 100 (FIG. 1A) according to embodiments herein may provide a number of advantages. These advantages include providing a forksheet FET structure 102 (FIG. 1A) in which two adjacent (side by side) transistors have the same conductivity type. This can be accomplished by using a second gate structure 130 (FIG. 1B) in the place of a conventional dielectric wall. The second gate structure 130 includes a conductive wall 132 (FIG. 1B) that facilitates additional control of a threshold voltage of the two adjacent transistors. Moreover, the conductive wall 132 can reduce an electrical-coupling effect between the two adjacent transistors (and thus can serve an isolation role that would typically be performed by an electrical insulator).

According to some embodiments, the second gate structure 130 may be located at a cell boundary CB1 (FIG. 3A). Moreover, the second gate structure 130 can control (e.g., increase or decrease) a device threshold voltage with back-gate biasing.

In some embodiments, a stacked forksheet FET structure 302 (FIG. 3B) includes second and third gate structures 130, 230 (FIG. 3B) that are electrically isolated from each other so that they can individually control threshold voltages of upper and lower FETs, respectively. The second and third gate structures 130, 230 are provided in addition to main first and fourth gate structures 180, 280 of the stacked forksheet FET structure 302, and thus can provide additional threshold-voltage control beyond what is provided by the main first and fourth gate structures 180, 280.

By providing additional threshold-voltage control, various embodiments herein can allow design flexibility to help optimize power and performance of a device. For example, a lower threshold voltage may be beneficial for high-performance computing (HPC) technology (e.g., to increase a frequency thereof), whereas a higher threshold voltage may be beneficial for system-on-chip (SoC) technology (e.g., to reduce leakage thereof).

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. A forksheet field-effect transistor, FET, device comprising:
a first FET (116a) comprising a first conductive gate material (182);
a second FET (116b) that is adjacent to the first FET (116a) and that comprises the first conductive gate material (182); and
a second conductive gate material (132) that is between the first FET (116a) and the second FET (116b) and that is different from the first conductive gate material (182).

2. The forksheet FET device of claim 1,
wherein the second conductive gate material (132) is comprised in a conductive wall (132) that separates the first FET (116a) from the second FET (116b).

3. The forksheet FET device of claim 2,
wherein the first FET (116a) and the second FET (116b) each comprise at least one semiconductor channel layer (124a; 124b),
wherein the conductive wall (130) is part of a gate structure (130) that separates the first FET (116a) from the second FET (116b), and
wherein the gate structure (130) further comprises a dielectric material (134) that separates the conductive wall (132) from the at least one semiconductor channel layer (124a; 124b).

4. The forksheet FET device of claim 3,
wherein the dielectric material (134) comprises silicon dioxide or an oxide that has a higher dielectric constant than silicon dioxide, and
wherein the dielectric material (134) is on opposite sides of the conductive wall (132) and is in contact with both the first FET (116a) and the second FET (116b).

5. The forksheet FET device of claim 3 or 4, wherein the at least one semiconductor channel layer (124a; 124b) comprises a plurality of semiconductor channel layers (124a; 124b), and wherein the conductive wall (132) extends continuously from a lower level that is lower than a lowermost one of the semiconductor channel layers (124a; 124b) to an upper level that is higher than an uppermost one of the semiconductor channel layers (124a; 124b).

6. The forksheet FET device of any one of claims 2 to 5, wherein the conductive wall (132) is at a cell boundary (CB1) of the forksheet FET device (200; 300), and/or
wherein the conductive wall (132) is configured to control a threshold voltage of the forksheet FET device (100; 200; 300).

7. The forksheet FET device of any one of claims 2 to 6, further comprising:
a first gate contact (170) that is on the first conductive gate material (182) and is configured to bias a first gate structure (180) that includes the first conductive gate material (182); and
a second gate contact (172) that is on the conductive wall (132) and is configured to bias a second gate structure (130) that includes the conductive wall (132).

8. The forksheet FET device of claim 7, wherein the second gate contact (172) is in contact with the conductive wall (130).

9. The forksheet FET device of any one of claim 1 to 8, wherein the first FET (116a) and the second FET (116b) each comprise the same conductivity type, or are both p-type metal-oxide-semiconductor, PMOS, transistors or are both n-type metal-oxide-semiconductor, NMOS, transistors.

10. The forksheet FET device of any one of claims 2 to 8,
wherein the forksheet FET device (300) comprises a stacked forksheet FET structure (302) in which the first FET (116a) is a first lower FET (116a) and the second FET (116b) is a second lower FET (116b) that is separated from the first lower FET (116a) by the conductive wall (132),
wherein the stacked forksheet FET structure (302) further comprises:
a first upper FET (116c) that is on top of the first lower FET (116a); and
a second upper FET (116d) that is on top of the second lower FET (116b), and
wherein the first lower FET (116a) and the second lower FET (116b) each comprise a p-type metal-oxide-semiconductor, PMOS, transistor and the first upper FET (116c) and the second upper FET (116d) each comprise an n-type metal-oxide-semiconductor, NMOS, transistor, or vice versa.

11. The forksheet FET device of claim 10, further comprising a second conductive wall (232) that separates the first upper FET (116c) from the second upper FET (116d),
wherein the first conductive gate material (182) is part of a first gate structure (180),
wherein the conductive wall (132) that separates the first lower FET (116a) from the second lower FET (116b) is part of a second gate structure (130),
wherein the second conductive wall (232) is part of a third gate structure (230), and
wherein the second conductive wall (232) is on top of the conductive wall (130).

12. The forksheet FET device of claim 11, further comprising an isolation region (320) that separates the second conductive wall (232) of the third gate structure (230) from the conductive wall (132) of the second gate structure (130),
wherein the second gate structure (130) is configured to control a threshold voltage of the first lower FET (116a) and the second lower FET (116b), and
wherein the third gate structure (230) is configured to control a threshold voltage of the first upper FET (116c) and the second upper FET (116d).

13. The forksheet FET device of claim 12, further comprising a third conductive wall (330) that is adjacent to a sidewall of the first upper FET (116c) and a sidewall of the first lower FET (116a),
wherein the third conductive wall (330) is spaced apart from the isolation region (320).

14. The forksheet FET device of any one of claims 2 to 8,
wherein the first FET (116a) and the second FET (116b) each comprise a p-type metal-oxide-semiconductor, PMOS, transistor,
wherein the first conductive gate material (182) is part of a first gate structure (180),
wherein the conductive wall (130) that separates the first FET (116a) from the second FET (116b) is part of a second gate structure (130),
wherein the forksheet FET device (200) further comprises:
a third FET (116c) and a fourth FET (116d) that each comprise an n-type metal-oxide-semiconductor, NMOS, transistor; and
a third gate structure (230) comprising a second conductive wall (232) that separates the third FET (116c) from the fourth FET (116d),
wherein the third FET (116c) is adjacent to and side by side with the second FET (116b), and
wherein the third FET (116c) is between the second FET (116b) and the fourth FET (116d).

15. The forksheet FET device of claim 14, wherein the second conductive wall (232) of the third gate structure (230) comprises a different metal from that of the conductive wall (130) of the second gate structure (130).

16. The forksheet FET device of any one of claims 1 to 15,
wherein the first conductive gate material (182) comprises a first metal, and wherein the second conductive gate material (132) comprises a second metal that is different from the first metal.

17. A forksheet field-effect transistor, FET, device comprising:
a first FET (116a);
a second FET (116b) that is side by side with the first FET (116a) and that has the same conductivity type as the first FET (116a); and
a gate material (132) that separates the first FET (116a) from the second FET (116b) and that is configured to control a threshold voltage of the forksheet FET device (100; 200; 300).

18. The forksheet FET device of Claim 17,
wherein the first FET (116a) and the second FET (116b) each comprise a first gate metal (182), and
wherein the gate material (132) comprises a second gate metal that is different from the first gate metal.
